## Europäisches Patentamt

## European Patent Office

## Office européen des brevets

(19)

(11) Veröffentlichungsnummer: **0 363 831 B1**

(12) **EUROPÄISCHE PATENTSCHRIFT**

(45) Veröffentlichungstag der Patentschrift:
27.12.91 Patentblatt 91/52

(51) Int. Cl.⁵: **H01P 1/26,** G01R 31/00,
G01R 29/08

(21) Anmeldenummer: 89118544.9

(22) Anmeldetag: 06.10.89

(54) Reflexionsfreier Abschluss eines TEM-Wellenleiters.

(30) Priorität: 14.10.88 CH 3853/88

(43) Veröffentlichungstag der Anmeldung:
18.04.90 Patentblatt 90/16

(45) Bekanntmachung des Hinweises auf die
Patenterteilung:
27.12.91 Patentblatt 91/52

(84) Benannte Vertragsstaaten:
CH DE FR GB LI SE

(56) Entgegenhaltungen:
EP-A- 0 044 758

(56) Entgegenhaltungen:
EP-A- 0 246 544
DE-A- 3 503 181
FR-A- 2 360 969
US-A- 3 354 412
US-A- 4 605 916

(73) Patentinhaber: **ASEA BROWN BOVERI AG**
**Haselstrasse**
**CH-5401 Baden (CH)**

(72) Erfinder: **Hansen, Diethard, Dr.**
**Bahnhofstrasse 39a**
**CH-8965 Berikon (CH)**
Erfinder: **Königstein, Dietrich, Dr.**
**Oberriedenstrasse 61**
**CH-5412 Gebenstorf (CH)**

## Beschreibung

### Technisches Gebiet

Die Erfindung betrifft einen reflexionsfreien Abschluss eines TEM-Wellenleiters, bei welchem eine TEM-Welle durch einen Innenleiter und einen Aussenleiter geführt wird und an einem Ende des TEM-Wellenleiters von einem HF-Absorber zur Absorption der feldgebundenen Energie und einem ohmschen Leitungsabschluss zur Absorption der leitergebundenen Energie der TEM-Welle absorbiert wird.

### Stand der Technik

Aus der Patentanmeldung EP-A1-0246544 ist eine Vorrichtung zur EMI-Prüfung von elektronischen Geräten bekannt. Bei der EMI-Prüfung (EMI = Electrmagnetic Interference) von elektronischen Geräten weist sie gegenüber anderen Messeinrichtungen grosse Vorteile auf. Insbesondere schafft sie eine definierte Feldverteilung über einen weiten Frequenzbereich und kann auch zur breitbandigen Emissionsmessung eingesetzt werden.

Allerdings hat es sich gezeigt, dass unerwünschte, örtliche und frequenzabhängige Inhomogenitäten des Wellenfeldes auftreten. Dies hat damit zu tun, dass der Leitungsabschluss nicht hinreichend reflexionsfrei ist.

Ein Leitungsabschluss für TEM-Wellenleiter ist z.B. aus der Offenlegungsschrift DE-3130487A1 bekannt. Insbesondere wird dort der Innenleiter mit Abschlusswiderständen versehen, welche auf Aequipotentiallinien, also quer zur Ausbreitungsrichtung des Wellenfeldes, liegen. Messungen mit solchen Anordnungen haben aber gezeigt, dass diese für Frequenzen oberhalb 100 MHz nicht brauchbar sind.

### Darstellung der Erfindung

Aufgabe der Erfindung ist es, einen reflexionsfreien Abschluss eines TEM-Wellenleiters der eingangs genannten Art zu schaffen.

Erfindungsgemäss besteht die Lösung darin, dass bei einem solchen Leitungsabschluss für TEM-Wellenleiter

a) der Leitungsabschluss in einer durch den Innenleiter bestimmten und in Wellenrichtung liegenden Fläche liegt,

b) der Leitungsabschluss als ein ohmscher Widerstand ausgebildet ist, welcher eine graduelle, serielle Bedämpfung des Innenleiters bewirkt und

c) einen durch die HF-Absorber auf dem Leitungsabschluss zusätzlich hervorgerufenen Kapazitätsbelag lokal kompensiert.

Die Absorption der feldgebundenen Energie erfolgt in einer parallel zum ohmschen Abschluss angeordneten Absorberfläche.

Vorzugsweise weist der Leitungsabschluss gleichzeitig ein an die Stromverteilung quer zur Ausbreitungsrichtung der TEM-Welle angepasstes Widerstandsprofil auf.

Besonders vorteilhaft ist es, den erfindungsgemässen Leitungsabschluss bei einer Vorrichtung zur EMI-Prüfung elektronischer Geräte einzusetzen, wobei die Vorrichtung einen sich pyramidenfärmig aufweitenden TEM-Wellenleiter umfasst, welcher durch eine feldangepasste, kugelkalottenförmigen HF-Absorber mit HF-Spitzenabsorbern abgeschlossen ist.

Dadurch wird es möglich, die elektronischen Geräte nicht nur auf Einstrahlung zuverlässig zu testen, sondern auch deren Emission genau zu messen.

Weitere vorteilhafte Ausführungsformen der Erfindung ergeben sich aus den abhängigen Patentansprüchen.

### Kurze Beschreibung der Zeichnungen

Nachfolgend soll die Erfindung anhand von Ausführungsbeispielen und im Zusammenhang mit der Zeichnung näher erläutert werden. Es zeigen :

Fig. 1    eine Vorrichtung zur EMI-Prüfung elektronischer Geräte ;
Fig. 2    einen Leitungsabschluss gemäss dem Stand der Technik ;
Fig. 3    einen Leitungsabschluss gemäss der Erfindung ; und
Fig. 4    einen Leitungsabschluss in der Form eines diskreten Widerstandsnetzes.

## Wege zur Ausführung der Erfindung

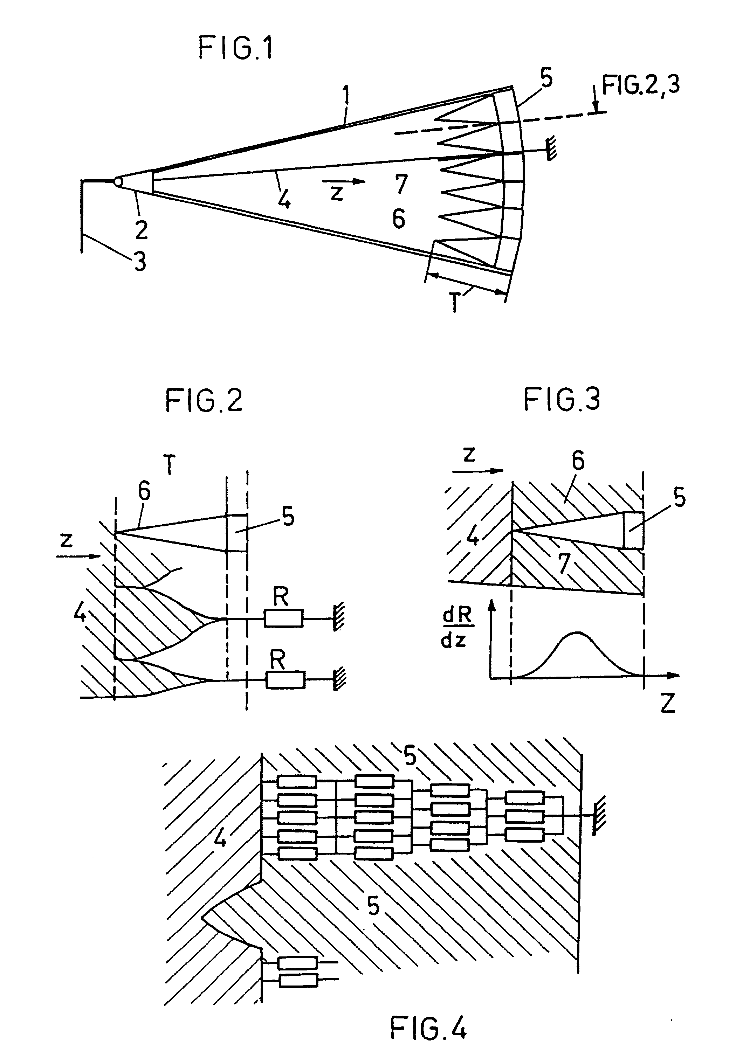

Fig. 1 zeigt die wesentlichen Teile einer Vorrichtung zur EMI-Prüfung elektronischer Geräte. Sie umfasst einen TEM-Wellenleiter mit einem Aussenleiter 1, einem asymmetrischen Innenleiter 4, einen Speisekeil 2 und einen HF-Absorber 5. Ein Koaxialkabel 3 führt z.B. eine impuls- oder sinusförmige Hochfrequenz (HF) dem Speisekeil 2 zu, der eine TEM-Welle (TEM = transversal elektromagnetisch) erzeugt und in den TEM-Wellenleiter einkoppelt.

Der TEM-Wellenleiter weitet sich von einer Spitze her pyramidenförmig auf. Der HF-Absorber 5 befindet sich am aufgeweiteten Ende des TEM-Wellenleiters und ist kugelkalottenförmig. Er ist mit HF-Spitzenabsorbern 6 versehen und an das gewünschte, sich im TEM-Wellenleiter ausbreitende Wellenfeld angepasst. D.h. er absorbiert den feldgebundenen Teil der Energie der TEM-Welle.

Der TEM-Wellenleiter ist als solcher ausführlich in der Schweizer Patentanmeldung CH-2026/86-9 beschrieben, deren Inhalt hiermit in der vorliegenden Anmeldung eingeschlossen wird.

Der Innenleiter 1 ist plattenförmig und ist am breiten Ende des TEM-Wellenleiters 1 mit einem Leitungsabschluss 7 versehen. Dieser Leitungsabschluss 7 ist gemäss der Erfindung so ausgeführt, dass der leitergebundene Teil der Energie der TEM-Welle absorbiert wird. Durch diesen Leitungsabschluss können keine Störungen entstehen und gleichzeitig werden Störmoden, die aus anderen Gründen entstanden sind, bedämpft. Im folgenden werden die wesentlichen Punkte diskutiert, die zu beachten sind, um die gewünschten Effekte zu erhalten.

Erstens muss der Leitungsabschluss 7 in geometrischer Hinsicht so angeordnet sein, dass er in einer durch den Innenleiter 4 bestimmten Fläche liegt. Er stellt also eine ebene Weiterführung des Innenleiters 4 in Richtung des Wellenfeldes dar. (In Fig. 1 zeigt ein mit z bezeichneter Pfeil die Richtung des Wellenfelddes an.) Ein im Innenleiter 4 fliessender Strom wird also knickfrei abgeführt. Dadurch dass die Stromausbreitung in Wellenrichtung nicht gestört wird, entstehen keine unerwünschten Moden.

Zweitens muss der Leitungsabschluss 7 als ein ohmscher Widerstand ausgebildet sein, welcher eine graduelle serielle Bedämpfung des Innenleiters 4 bewirkt. Dies soll anhand der Figuren 2 und 3 erläutert werden.

Fig. 2 zeigt, wie der Innenleiter 4 beim Stand der Technik abgeschlossen wird. (in den Figuren 2 und 3 wird eine Draufsicht auf die Fläche des Innenleiters 4 gezeigt.) In einem Endbereich T, welcher durch die Dicke des HF-Absorbers 5 gegeben ist, wird das erzeugte Wellenfeld abgedämpft. Der Innenleiter 4 ist in diesem Endbereich zahnförmig konturiert und endet dort, wo die HF-spitzenabsorber 6 aneinanderstossen. Die Zahnspitzen sind mit einem Draht durch den zusammenhängenden Teil des HF-Absorbers 5 hindurchgeführt und dahinter mit einem ohmschen Widerstand R abgeschlossen.

Fig. 3 zeigt wie der erfindungsgemässe Leitungsabschluss 7 den Innenleiter 4 abschliesst. Wie in Fig. 2 sind der HF-Absorber 5 und ein HF-Spitzenabsorber 6 angedeutet. Der Leitungsabschluss 7 deckt den ganzen Endbereich T ab. Er führt also auch durch den zusammenhängenden Teil des HF-Absorbers 5 hindurch. Er ist flächenhaft ausgebildet und besitzt in Ausbreitungsrichtung des Wellenfeldes ein Widerstandsprofil dR/dz, welches den durch den HF-Absorber 5 auf dem Leitungsabschluss 7 zusätzlich hervorgerufenen Kapazitätsbelag lokal kompensiert. An jeder Stelle "sieht" die TEM-Welle also den lokal angepassten Wellenwiderstand.

Im allgemeinen Fall steigt das Widerstandsprofil dR/dz von einem kleinen Wert beim Uebergang Innenleiter/Leitungsabschluss an auf ein Maximum und fällt dann gegen Ende des Endbereichs wieder auf einen kleinen Wert ab.

Gemäss einer bevorzugten Ausführungsform der Erfindung weist der Leitungsabschluss gleichzeitig ein an die Stromverteilung quer zur Ausbreitungsrichtung der TEM-Welle angepasstes Widerstandsprofil auf. Auf diese Weise wird vermieden, dass die grossen Stromkomponenten am seitlichen Rand den Innenleiters nicht quer zur Ausbreitungsrichtung der TEM-Welle gestreut werden. Endsprechend ist das Widerstandsprofil quer zur Richtung des Wellenfeldes, d.h. von der Mitte des Leitungsabschlusses gegen die Seiten hin abfallend. Quantitativ betrachtet, wird das Widerstandsprofil also an den Kanten des Leitungsabschlusses die kleinsten Werte haben.

Der Leitungsabschluss 7 ist schliesslich so ausgebildet, dass ein durch dene HF-Absorber 5 und die HF-Spitzenabsorber 6 auf dem Innenleiter 4 zusätzlich hervorgerufener Kapazitätsbelag lokal kompensiert wird.

Der erfindungsgemässe Leitungsabschluss 7 lässt sich vorzugsweise so realisieren, dass eine Trägerplatte, z.B. eine Sperrholzplatte, mit einer Widerstandsschicht, z.B. Graphitbelag mit geeigneter ortsabhängiger Dicke, versehen wird. Damit der Strom möglichst störungsfrei vom Innenleiter 4 auf den Widerstandsbelag geführt wird, kann auf der Trägerplatte ein metallischer, zahnförmiger Uebergangsbereich vorgesehen sein.

Fig. 4 zeigt eine weitere Ausführungsform. Bei dieser ist die ohmsche serielle Bedämpfung des Leitungsabschlusses durch ein Netzwerk von diskreten Widerständen realisiert.

Als Trägerplatte eignet sich eine faserverstärkte Kunststoffplatte. Je nach Material wird diese mit einer geeigneten Widerstandsschicht bedeckt oder gleich selbst als Widerstand benutzt.

Die Erfindung beschränkt sich jedoch nicht auf die beschriebenen Ausführungsbeispiele. Insbesondere eignet sie sich auch für offene resp. halboffene TEM-Wellenleiter, bei welchen also der Aussenleiter auf ein oder mehreren Seiten offen ist.

Im folgenden werden weitere Eigenschaften und Vorteile der Erfindung stichwortartig aufgezählt:

1. Die Erfindung schafft eine deutliche Qualitätssteigerung in bezug auf die Feldhomogenität im gesamten Testvolumen und Frequenzbereich.
2. Es ist damit möglich, deutlich grössere Prüfkammern hoher Qualität zu bauen (z.B. für Anlagen und Fahrzeuge).
3. Die Herstellungskosten des Abschlussbereichs von Breitbandzellen werden gesenkt.
4. Die Kühlung des flächenhaft verteilten Abschlusswiderstandes ist gegenüber den diskreten Widerständen beim Stand der Technik besser und einfacher. Entsprechend kann die Prüfkammer für höhere Betriebsfeldstärken eingesetzt werden. Ebenso ist dadurch eine grössere Bauhöhe möglich.
5. Die Hochspannungsfestigkeit wird grösser.
6. Aufgrund der hohen Feldqualität ist eine präzise Korrelation zu normgerechten Freifeld-Emissionswerten möglich.
7. Die Erfindung kann auch zum Abschliessen offener Wellenleiteranordnungen eingesetzt werden.
8. Schliesslich lassen sich gemäss der Erfindung breitbandige, hochleistungs- und hochspannungsfeste Abschlusslasten (sogenannte Dummy-loads) aufbauen.

Abschliessend kann gesagt werden, dass mit der Erfindung ein breitbandiger, reflexionsfreier Leitungsabschluss geschaffen wird, welcher sich überall dort mit grossem Vorteil einsetzen lässt, wo eine hohe Leistung vernichtet werden muss.

## Patentansprüche

1. Reflexionsfreier Abschluss eines TEM-Wellenleiters, bei welchem eine TEM-Welle durch einen Innenleiter (4) und einen Aussenleiter (1) geführt wird und an einem Ende des TEM-Wellenleiters von einem HF-Absorber (5) zur Absorption einer feldgebundenen Energie und einem ohmschen Leitungsabschluss (7) zur Absorption einer leitergebundenen Energie der TEM-Welle absorbiert wird, dadurch gekennzeichnet, dass
a) der Leitungsabschluss (7) in einer durch den Innenleiter (4) bestimmten und in Wellenrichtung liegenden Fläche liegt,
b) der Leitungsabschluss (7) als ein ohmscher Widerstand ausgebildet ist, welcher eine graduelle, serielle Bedämpfung des Innenleiters (4) bewirkt und
c) einen durch den HF-Absorber (5) auf dem Leitungsabschluss (7) zusätzlich hervorgerufenen Kapazitätsbelag lokal kompensiert.
2. Reflexionsfreier Abschluss eines TEM-Wellenleiters nach Anspruch 1, dadurch gekennzeichnet, dass der TEM-Wellenleiter ein geschlossener TEM-Wellenleiter ist.
3. Reflexionsfreier Abschluss eines TEM-Wellenleiters nach Anspruch 1, dadurch gekennzeichnet, dass der TEM-Wellenleiter ein offener TEM-Wellenleiter ist.
4. Reflexionsfreier Abschluss eines TEM-Wellenleiters nach Anspruch 1, dadurch gekennzeichnet, dass der Leitungsabschluss (7) eine Trägerplatte mit einer Widerstandsschicht umfasst.
5. Reflexionsfreier Abschluss eines TEM-Wellenleiters nach Anspruch 1, dadurch gekennzeichnet, dass der Leitungsabschluss ein Netzwerk von diskreten Widerständen umfasst.
6. Reflexionsfreier Abschluss eines TEM-Wellenleiters nach Anspruch 4, dadurch gekennzeichnet, dass die Widerstandsschicht aus Graphit besteht und eine ortsabhängige Dicke aufweist.
7. Reflexionsfreier Abschluss eines TEM-Wellenleiters nach Anspruch 4, dadurch gekennzeichnet, dass die Trägerplatte eine faserverstärkte Kunststoffplatte ist.
8. Reflexionsfreier Abschluss eines TEM-Wellenleiters nach Anspruch 1, dadurch gekennzeichnet, dass der Leitungsabschluss durch eine faserverstärkte Kunststoffplatte gebildet wird.
9. Reflexionsfreier Abschluss eines TEM-Wellenleiters nach Anspruch 1, dadurch gekennzeichnet, dass der Leitungsabschluss gleichzeitig ein an eine Stromverteilung quer zur Ausbreitungsrichtung der TEM-Welle angepasstes Widerstandsprofil aufweist.
10. Vorrichtung zur EMI-Prüfung elektronischer Geräte mit einem sich pyramidenförmig aufweitenden TEM-Wellenleiter, welcher durch eine feldangepasste, kugelkalottenförmigen HF-Absorber (5) mit HF-Spitzenabsorbern (6) abgeschlossen ist, und welcher einen plattenförmigen Innenleiter (4) mit einem Leitungsabschluss (7) aufweist, dadurch gekennzeichnet, dass

4

a) der Leitungsabschluss (7) in einer durch den Innenleiter (4) bestimmten und in Wellenrichtung liegenden Fläche liegt,

b) der Leitungsabschluss (7) als ein ohmscher Widerstand ausgebildet ist, welcher eine graduelle, serielle Bedämpfung des Innenleiters (4) bewirkt und

c) einen durch den HF-Absorber (5) auf dem Leitungsabschluss (7) zusätzlich hervorgerufenen Kapazitätsbelag lokal kompensiert.

## Claims

1. Reflection-free termination of a TEM waveguide, in which a TEM wave is conducted through an inner conductor (4) and an outer conductor (1) and is absorbed at one end of the TEM waveguide by an RF absorber (5) for absorbing a field energy and by an ohmic line termination (7) for absorbing a conductor-guided energy of the TEM wave, characterised in that

a) the line termination (7) is located in a plane determined by the inner conductor (4) and located in the wave direction,

b) the line termination (7) is constructed as an ohmic resistance which produces a gradual, serial damping on the inner conductor (4) and

c) locally compensates for a capacitance loading additionally produced at the line termination (7) by the RF absorber (5).

2. Reflection-free termination of a TEM waveguide according to Claim 1, characterised in that the TEM waveguide is a closed TEM waveguide.

3. Reflection-free termination of a TEM waveguide according to Claim 1, characterised in that the TEM waveguide is an open TEM waveguide.

4. Reflection- free termination of a TEM waveguide according to Claim 1, characterised in that the line termination (7) comprises a support plate with a resistance layer.

5. Reflection- free termination of a TEM waveguide according to Claim 1, characterised in that the line termination comprises a network of discrete resistors.

6. Reflection-free termination of a TEM waveguide according to Claim 4, characterised in that the resistance layer consists of graphite and exhibits a location-dependent thickness.

7. Reflection-free termination of a TEM waveguide according to Claim 4, characterised in that the support plate is a fibre-reinforced plastic plate.

8. Reflection-free termination of a TEM waveguide according to Claim 1, characterised in that the line termination is formed by a fibre-reinforced plastic plate.

9. Reflection-free termination of a TEM waveguide according to Claim 1, characterised in that the line termination, at the same time, exhibits a resistance contour which matches a current distribution across the direction of propagation of the TEM wave.

10. Device for EMI testing electronic equipment by means of a pyramidally expanding TEM waveguide which is terminated by a field-matched spherical-cap-shaped RF absorber (5) with RF point absorbers (6) and which exhibits a plate-shaped inner conductor (4) with a line termination (7), characterised in that

a) the line termination (7) is located in a plane determined by the inner conductor (4) and located in the wave direction,

b) the line termination (7) is constructed as an ohmic resistance which produces a gradual, serial damping on the inner conductor (4) and

c) locally compensates for a capacitance loading additionally produced at the line termination (7) by the RF absorber (5).

## Revendications

1. Terminaison sans réflexion d'un guide d'ondes TEM, dans laquelle une onde TEM est guidée à travers un guide interne (4) et un guide externe (1) et est absorbée à une extrémité du guide d'ondes TEM par un absorbeur HF (5) servant à absorber l'énergie liée au champ et par une terminaison de ligne ohmique (7) destinée à absorber l'énergie, liée au guide, de l'onde TEM caractérisée en ce que :

a) la terminaison de ligne (7) est située dans un plan déterminé par le guide interne (4) et s'étendant dans le sens des ondes ;

b) la terminaison de ligne (7) a la forme d'une résistance ohmique qui assure un affaiblissement sériel graduel du guide interne (4), et

c) compense localement une charge capacitive produite en supplément sur la terminaison de ligne (7) par l'absorbeur HF (5).

2. Terminaison sans réflexion d'un guide d'ondes TEM suivant la revendication 1, caractérisée en ce que le guide d'ondes TEM est un guide d'ondes TEM fermé.

3. Terminaison sans réflexion d'un guide d'ondes TEM suivant la revendication 1, caractérisée en ce que le guide d'ondes TEM est un guide d'ondes TEM ouvert.

4. Terminaison sans réflexion d'un guide d'ondes TEM, suivant la revendication 1, caractérisée en ce que la terminaison de ligne (7) comporte une plaque de support pourvue d'une couche résistante.

5. Terminaison sans réflexion d'un guide d'ondes TEM suivant la revendication 1, caractérisée en ce que la terminaison de ligne comporte un réseau de résistances discrètes.

6. Terminaison sans réflexion d'un guide d'ondes TEM suivant la revendication 4, caractérisée en ce que la couche résistante est constituée de graphite et presente une épaisseur dépendant du lieu.

7. Terminaison sans réflexion d'un guide d'ondes TEM suivant la revendication 4, caractérisée en ce que la plaque de support est une plaque en matière plastique renforcée par des fibres.

8. Terminaison sans réflexion d'un guide d'ondes TEM suivant la revendication 1, caractérisée en ce que la terminaison de ligne est formée par une plaque de matière plastique renforcée par des fibres.

9. Terminaison sans réflexion d'un guide d'ondes TEM suivant la revendication 1, caractérisée en ce que la terminaison de ligne présente en même temps un profil résistant adapté à une répartition de courant transversalement au sens de propagation de l'onde TEM.

10. Dispositif pour l'essai EMI d'appareils électroniques comportant un guide d'ondes TEM s'élargissant en forme de pyramide qui est terminé par un absorbeur HF (5) en forme de calotte sphérique adapté au champ, présentant des absorbeurs en pointe HF (6) et comprenant un guide interne en forme de plaque (4) avec une terminaison de ligne (7), caractérisé en ce que :

a) la terminaison de ligne (7) est située dans un plan déterminé par le guide interne (4) et s'étendant dans le sens des ondes ;

b) la terminaison de ligne (7) a la forme d'une résistance ohmique qui assure un affaiblissement sériel graduel du guide interne (4), et

c) compense localement une charge capacitive produite en supplément sur la terminaison de ligne (7) par l'absorbeur HF (5).

# FIG.1

# FIG.2

# FIG.3

FIG.4